# EUROPEAN PATENT APPLICATION

(11) **EP 1 357 780 A2**
(43) Date of publication of application: **29.10.2003**
(21) Application number: 03008934.6
(22) Date of filing: 16.04.2003
(51) Int. Cl.: H05K 9/00

(54) **Camera module having a shield casing and a sealing mechanism**

(30) Priority: 24.04.2002 JP 2002122928
(71) Applicant: Kabushiki Kaisha Toshiba, Tokyo (JP)
(72) Inventor: Asaga, Jun, Kabushiki Kaisha Toshiba, Intellectual, Tokyo 105-8001 (JP); Mukaigawa, Hiroshi, K.Kaisha Toshiba, Intellectual, Tokyo 105-8001 (JP); Hashimoto, Kazuaki, K.Kaisha Toshiba, Intellectual, Tokyo 105-8001 (JP); Sasaki, Tomoyuki, K. Kaisha Toshiba, Intellectual, Tokyo 105-8001 (JP); Shimane, Akio, K. Kaisha Toshiba, Intellectual, Tokyo 105-8001 (JP)
(74) Representative: Henkel, Feiler, Hänzel

(57) **Abstract**

An electronic device comprises a substrate (30) mounting an electronic component (34), a shielding case (32) molded with conductive resin and connected to the substrate (30), and a conductive coating (32b) formed on the surface of the shielding case. Since the shielding case is molded from the conductive resin, it is possible to mold the case into any shapes and provide smaller and lighter cases than the metal ones.

## Description

The present invention relates to an electronic device having a shield and/or a sealing mechanism.

In recent years, such electronic device is represented by a camera module built in cellular phones and personal digital assistants. It is desired that such camera module is small and light-weight. The small electronic device needs to shield (EMI shield) each component in order to prevent radio noise interference between the components. A portable device having the communication function causes the following problems when the camera module and an antenna are arranged adjacently to each other. If noises from the antenna enter the camera module (image pickup element), an image signal degraded. If the camera module (image pickup element or digital signal processor) generates an electromagnetic wave near the antenna, its receiving sensitivity decreases. Further, it should not ignore an effect of the electromagnetic wave from the camera module on the human body. Accordingly, the camera module needs to be shielded. Since these portable devices are subject to higher density assembly and use higher frequencies year after year, there is an increasing demand for a shielding case.

In the conventional camera module, a camera module comprising a substrate, an image pickup element arranged on the substrate, and a lens and color filter holder connected to the substrate by means of adhesive, is covered with a metal shielding case. The shielding case is connected to the lens holder at the top and is soldered to the substrate at the bottom. The substrate is connected to a case ground, ensuring the camera module ground.

Since the entire camera module is covered with the metal shielding case configured to be an independent member, the shielding case becomes larger and heavier than the camera module itself. This is inappropriate to a shielding structure for the electronic device to be built in the small, light-weight portable device. The metal shielding case is manufactured through a process that is a combination of bending and pressing. Consequently, it is difficult to realize a complicated shape of the shielding case itself. An external shape of the shielding case is limited to a rectangular column that entirely covers the camera module.

The image pickup element must be protected against moisture and dust and therefore must be sealed. According to the conventional camera module, the lens and filter holder is sealed to the substrate by means of the adhesive. Generally, thermosetting adhesive is used for the adhesive. During a thermosetting process of the adhesive, the heat may swell air in the lens holder. The swelled air increases the air pressure in the lens holder. An increase in the air pressure may break an adhesive layer for the connection portion between the lens holder and the substrate, impairing the sealing structure. When the adhesive layer is broken, the adhesive may scatter and remain in the lens holder to become dusts to the image pickup element. When the adhesive layer breaks, fine holes are often generated and may not be found by the naked eye.

It is an object of the present invention to provide an electronic device having a small and light-weight shielding structure with an improved shielding performance.

It is another object of the present invention to provide an electronic device having a sealing structure capable of easily and reliably ensuring sealing performance of the electronic device.

According to an embodiment of the present invention, an electronic device comprises a substrate mounting an electronic component, a shielding case formed from conductive resin and connected to the substrate, and a conductive coating formed on a surface of the shielding case.

According to anther embodiment of the present invention, an electronic device comprises a substrate mounting an electronic component, a case connected to the substrate for sealing the electronic component, a venthole formed in the substrate, and a sealing member filled in the venthole.

This summary of the invention does not necessarily describe all necessary features so that the invention may also be a sub-combination of these described features.

The invention can be more fully understood from the following detailed description when taken in conjunction with the accompanying drawings, in which:
FIG. 1 shows a structure of a cellular phone equipped with a camera module as the electronic device according to a first embodiment of the present invention;
FIG. 2 is a perspective view of the electronic device according to the first embodiment of the present invention;
FIG. 3 shows a shielding structure of the electronic device according to the first embodiment of the present invention;
FIG. 4 shows a shielding structure of the electronic device according to a second embodiment of the present invention; and
FIG. 5 shows a sealing structure of the electronic device according to a third embodiment of the present invention.

An embodiment of an electronic device according to the present invention will now be described with reference to the accompanying drawings.

### First embodiment

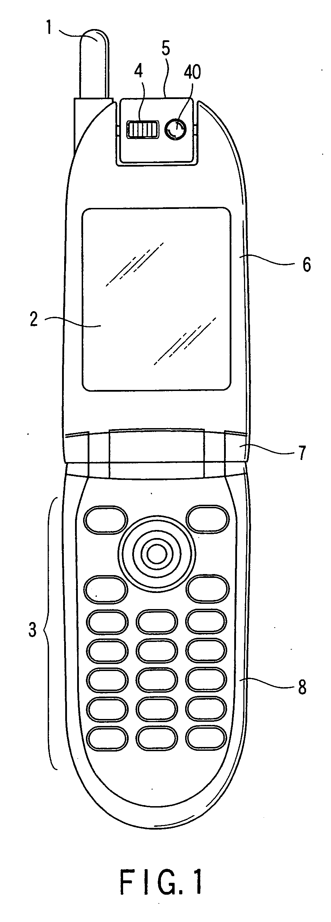

FIG. 1 shows a structure of a cellular phone equipped with a camera module as the electronic device according to the first embodiment. An upper case 6 is foldably connected to a lower case 8 via a hinge 7.
The upper case 6 is provided with an antenna 1, a camera module 5, and an LCD display 2. The lower case 8 is provided with a keyboard 3. The camera module 5 can pivot on a horizontal axis so that a lens can direct the front (foreground in FIG. 1) and the rear (background in FIG. 1).

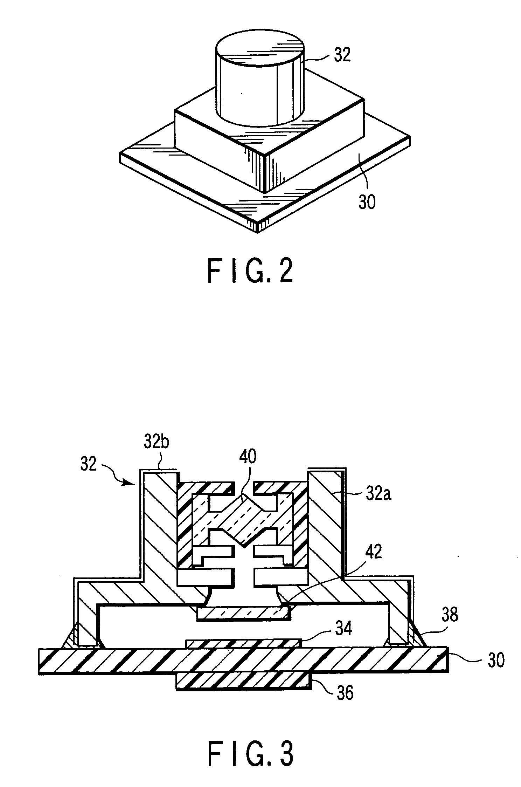

FIG. 2 is a perspective view showing the configuration of a camera module as the electronic device according to the first embodiment. The camera module comprises an optical system, an image pickup element, and an image processor, and generates an image (still picture) signal or a video (motion picture) signal. A lens holder 32 is fixed to a substrate 30. The lens holder 32 has a dual structure comprising a cylinder and a rectangular column. The cylinder holds a lens. The rectangular column contains a color filter and the image pickup element.

FIG. 3 is a sectional view showing a camera module according to the first embodiment. An image pickup element (e.g., CMOS sensor or CCD sensor) 34 is arranged on an upper surface of a substrate 30.
An image processor chip 36 is arranged on a lower surface thereof. A lens holder 32 is fixed to the substrate 30 by means of conductive adhesive 38.
A ground pattern (not shown) is formed on the substrate 30. The lens holder 32 is connected to the ground pattern. The ground pattern is connected via a contact (not shown) to another ground pattern of the apparatus case where the camera module is installed. The lens holder 32 holds a lens 40 above the image pickup element 34 and also holds a color filter 42. The lens holder 32 comprises a body 32a and a conductive coating 32b. The body 32a comprises conductive resin formed in the above-mentioned dual structure. The conductive coating 32b is formed on the surface of the body 32a.

Generally, the conductive resin is manufactured by mixing conductive fiber with the resin. Due to various factors in manufacturing processes, the resin may concentrate on the surface to form a skin layer, making it impossible to obtain stable conductivity on the surface. That is to say, a contact surface with the substrate 30 does not necessarily provide conductivity. Accordingly, the lens holder 32 may not conductively contact with the ground pattern of the substrate 30. As a solution, a metal material is embedded in the joint when the lens holder 32 to be used is simply made of conductive resin. When a screw engages with the metal-embedded portion, the screw ensures grounding and a connection between the holder and the substrate. Consequently, the lens holder becomes larger, and a work for making connection to the substrate consumes time and effort. Further, the conductive resin has conductivity but is less conductive than metal and cannot provide sufficient shield effect.

To solve this, the embodiment forms the conductive coating 32b such as a vaporized layer on the surface of the conductive resin body 32a. The conductive coating 32b electrically connects to the conductive resin body 32a and easily electrically connects to the ground pattern on the substrate 30. It is possible to obtain shield effects of both the body 32a comprising the conductive resin and the conductive coating 32b. Because it is easy to ensure conduction on the surface of the conductive coating 32b, it can be connected to the ground on the apparatus via the ground pattern of the substrate 30, enabling the grounding to be enforced. The lens holder 32 according to the embodiment can be freely shaped because it is made of the conductive resin. Owing to the conductive coating 32b, the lens holder 32 can ensure the conductivity on the surface and reliably provide the shield effect.
Not only the conductive adhesive, but also solder or the like can be used as a conductive fixing member for connection between the lens holder 32 and the substrate 30. The conductive coating 32b is not limited to the vaporized layer and may be a conductor coated layer or a plated layer.

Since the shielding case is molded from conductive resin, it is possible to mold the case into any shapes and provide smaller and lighter cases than the metal ones. Further, since the conductive coating is formed on the conductive resin surface, it is possible to ensure the case grounding and improve the shield performance.

As mentioned above, the first embodiment forms the electronic device exterior such as the camera module's lens holder using a conductive resin that easily ensures conduction on the product surface by means of conductive coating such as vaporization. This allows for shield effects of both the conductive resin and the conductive coating formed on the surface. It is possible to ensure conduction to the conductive resin from the module surface without needing to embed metal fittings and the like, making the connection to the ground easy. This improves the degree of freedom in the method of conduction to the conductive resin's grounding, enabling the structure to reinforce the complicated, small, light-weight shield. When applied to the camera module, this structure makes it easy to provide countermeasures against EMI or effects of the image pickup element on the sensitivity. This is especially effective for the camera module built in small portable devices having the communication capability that are subject to higher density assembly and complicated effects of radio waves.

Other embodiments of the electronic device according to the present invention will be described. The same portions as those of the first embodiment will be indicated in the same reference numerals and their detailed description will be omitted.

### Second embodiment

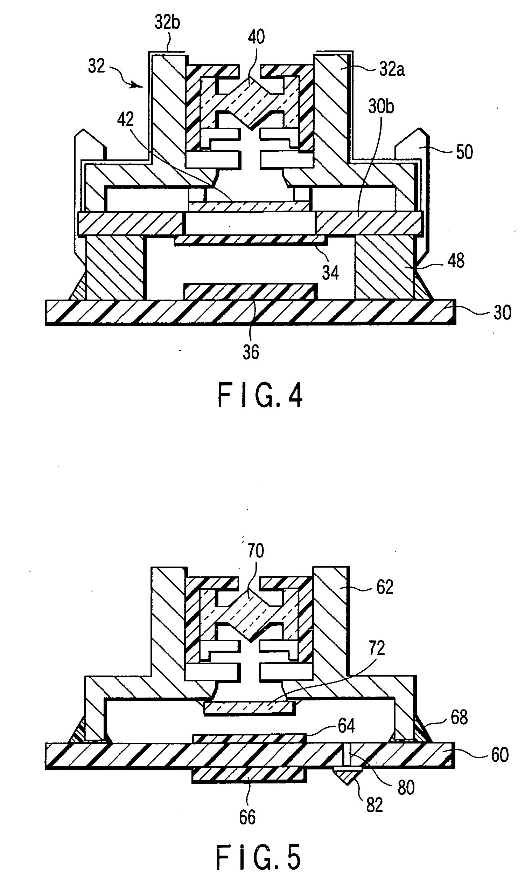

FIG. 4 is a sectional view showing a configuration of the camera module according to the second embodiment. The second embodiment is a modification of the first embodiment. An aperture is provided at the center of a second substrate 30b. The lower surface of the substrate 30b is provided with the image pickup element 34. An optical image is incident on the image pickup element 34 through the aperture. On the top surface of the substrate 30, the signal processing processor chip 36 is arranged and a connector 48 is provided. The connector 48 electrically connects patterns on the substrates 30 and 30b with each other. There is provided a fixing bracket 50 protruding from the connector 48. The fixing bracket 50 is used to fix the lens holder 32 to the substrate 30 by sandwiching the second substrate 30b therebetween. Accordingly, the conductive coating 32b on the surface of the lens holder 32 easily conducts to the ground pattern of the substrate 30 without using the adhesive 38 in the first embodiment. The fixing bracket 50 may be connected to the substrate 30 independently of the connector 48.

### Third embodiment

FIG. 5 is a sectional view showing a configuration of the camera module according to the third embodiment. The third embodiment relates to a sealing structure that prevents pressure in the case from increasing for sealed connection.

An image pickup element 64 is arranged on an upper surface of a substrate 60 and an image processor chip 66 is arranged on a lower surface thereof. A lens holder 62 is connected to the substrate 60 by means of thermosetting adhesive 68. The lens holder 62 holds not only a lens 70 above the image pickup element 64, but also a color filter 72. The substrate 60 is provided with a venthole 80 at periphery.

If the air in the lens holder 62 expands during a thermosetting process of the adhesive 68 between the lens holder 62 and the substrate 60, the air is exhausted outward from the venthole 80, preventing the internal air pressure from getting higher than the outside. As a result, no damage is caused to an adhesive layer for the connection between the lens holder 62 and the substrate 60. Then, the venthole 80 is filled with a sealing member 82 to form the sealing structure. The sealing member 82 is available as solder, ultraviolet curing resin, and the like. When solder is used for the sealing member 82,
a pattern (land) should be formed inside and around the venthole 80. As a result, the image pickup element 64 can be sealed reliably. The venthole 80 is provided at the periphery of the substrate 60. Therefore, if the sealing member 82 enters the holder 62 through the venthole 80, there is a little possibility of contaminating the surface of the image pickup element 64.

In FIG. 5, the lens holder 62 is not limited to any material. Like the first and second embodiments, it may be preferable to provide a shielding case by molding the body from the conductive resin and forming the conductive coating such as a vaporized layer on the surface.

Since the gas in the case is exhausted outside through the venthole during sealing, it is possible to prevent the air pressure in the case from increasing due to heat for hardening the adhesive. This can protect the adhesive layer against destruction and ensure the sealing structure.

As mentioned above, the embodiments of the present invention can provide the electronic device having the following working effects.
(1) Since the shielding case is molded from conductive resin, it is possible to mold the case into any shapes and provide smaller and lighter cases than the metal ones. Further, since the conductive coating is formed on the conductive resin surface, it is possible to ensure the case grounding and improve the shield performance.
(2) Since the gas in the case is exhausted outside through the venthole during sealing, it is possible to prevent the air pressure in the case from increasing due to heat for hardening the adhesive. This can protect the adhesive layer against destruction and ensure the sealing structure.

While the description above refers to particular embodiments of the present invention, it will be understood that many modifications may be made without departing from the spirit thereof. The accompanying claims are intended to cover such modifications as would fall within the true scope and spirit of the present invention. The presently disclosed embodiments are therefore to be considered in all respects as illustrative and not restrictive, the scope of the invention being indicated by the appended claims, rather than the foregoing description, and all changes that come within the meaning and range of equivalency of the claims are therefore intended to be embraced therein. For example, in the above-mentioned description, the electronic device is exemplified by the camera module built into the portable device having the communication function. The present invention is not limited thereto. Further, the present invention is applicable to not only electronic devices built into portable devices having the communication function, but also all devices that require a shield and/or sealing.

## Claims

1. An electronic device comprising:
a substrate (30) mounting an electronic component (34),
**characterized by** further comprising:
a shielding case (32) formed from conductive resin and connected to the substrate (30); and
a conductive coating (32b) formed on a surface of the shielding case (32).

2. An electronic device comprising:
a substrate (60) mounting an electronic component (64),
**characterized by** further comprising:
a case (62) connected to the substrate (60) for sealing the electronic component;
a venthole (80) formed in the substrate (60); and
a sealing member (82) filled in the venthole (80).

3. The electronic device according to claim 2,
**characterized in that**
the case (32) is formed from conductive resin; and
a conductive coating (32b) is formed on a surface of the case (32).

4. The electronic device according to claim 1 or 2, **characterized in that** the conductive coating (32b) comprises one of a vaporized layer, a conductor coated layer, and a plated layer.

5. The electronic device according to claim 1 or 2, **characterized in that** the conductive coating (32b) comprises a grounding layer.

6. The electronic device according to claim 1 or 2, **characterized in that** the shielding case (32) is connected to the substrate (30) through a conductive fixing member (38).

7. The electronic device according to any one of claims 1 to 6, **characterized in that**
the electronic component (34) comprises an image pickup element; and
the shielding case (32) comprises a lens holder.

8. The electronic device according to claim 2, **characterized in that** the sealing member comprises one of solder and ultraviolet curing resin.

9. A communication apparatus comprising:
a substrate (30) mounting an image pickup element,
**characterized by** further comprising:
a lens holder (32) which is formed from conductive resin, has a conductive coating formed on the surface, and is connected to the substrate.
